# EUROPÄISCHE PATENTSCHRIFT

(11) **EP 3 314 765 B1**
(45) Veröffentlichungstag und Bekanntmachung des Hinweises auf die Patenterteilung: **04.05.2022**
(21) Anmeldenummer: 16732286.6
(22) Anmeldetag: 24.06.2016
(51) Int. Cl.: H03K 17/18, G01R 31/26

(54) **SCHALTUNGSANORDNUNG FÜR EINEN SICHEREN DIGITALEN SCHALTAUSGANG SOWIE AUSGANGSMODUL MIT UND PRÜFVERFAHREN FÜR EINE DERARTIGE SCHALTUNGSANORDNUNG**
CIRCUIT ARRANGEMENT FOR A SECURE DIGITAL SWITCHED OUTPUT, TEST METHOD FOR - AND OUTPUT MODULE COMPRISING A DIGITAL CIRCUIT ARRANGEMENT OF THIS TYPE
MONTAGE DE CIRCUITS POUR SORTIE DE CIRCUIT NUMÉRIQUE SÛRE ET MODULE DE SORTIE AINSI QUE PROCÉDÉ DE CONTRÔLE D'UN TEL MONTAGE DE CIRCUITS

(30) Priorität: 25.06.2015 DE 202015103339 U
(43) Veröffentlichungstag der Anmeldung: 02.05.2018
(73) Patentinhaber: Weidmüller Interface GmbH & Co. KG, 32758 Detmold (DE)
(72) Erfinder: ROSE, Gorm, 33100 Paderborn (DE)
(74) Vertreter: Kleine, Hubertus
(86) Internationale Anmeldenummer: PCT/EP2016/064724
(87) Internationale Veröffentlichungsnummer: WO 2016/207382

(56) Entgegenhaltungen:
- EP-A1- 2 139 117
- EP-A2- 1 873 916
- DE-A1-102012 203 995
- US-A1- 2006 170 443

## Beschreibung

Die Erfindung betrifft eine Schaltungsanordnung mit einem sicheren digitalen Schaltausgang zum Anschluss einer zwischen dem Schaltausgang und einem weiteren Ausgang anschließbaren Last. Die Schaltungsanordnung weist wenigstens einen Halbleiterschalter auf, der mit einer Schaltstrecke zwischen einem Versorgungsspannungsanschluss und dem Schaltausgang angeordnet ist. Die Erfindung betrifft weiterhin ein Ausgangsmodul für eine Automatisierungssteuerung und ein Prüfverfahren für eine derartige Schaltungsanordnung.

Die genannte Schaltungsanordnung findet beispielsweise in digitalen Ausgangsmodulen von industriellen Automatisierungsteuerungen Verwendung. Für viele, insbesondere sicherheitskritische Anwendungen ist bei derartigen Ausgangsmodulen sicherzustellen, dass ein Schaltausgang sicher abschaltet, wenn dieses von der Automatisierungssteuerung oder einer zusätzlichen Sicherheitseinrichtung gefordert wird. Dies gilt insbesondere, wenn über den Schaltausgang ein Aktor angesteuert wird, von dessen Betrieb für Bediener einer Anlage eine Gefährdung hervorgehen kann.

Häufig werden, wie auch in der Europäischen Norm EN 13849-1 aus dem Jahre 2007 vorgegeben ist, zwei in Reihe geschaltete Halbleiterschalter eingesetzt, um beim Abschaltvorgang durch den redundanten Aufbau die Sicherheit, dass am Schaltausgang tatsächlich keine Versorgungsspannung mehr anliegt, zu erhöhen. Bei einer derartigen Reihenschaltung erfolgt eine Unterbrechung der Stromzufuhr, z.B. zu einem Aktor, auch noch dann, wenn einer der beiden Halbleiterschalter defekt ist und einen dauerhaft leitenden Zustand eingenommen hat.

Zusätzlich wird die korrekte Funktion, insbesondere das korrekte Abschalten der Schaltungsanordnung für den digitalen Schaltausgang in Betrieb regelmäßig durch ein Prüfverfahren überprüft.

Dazu kann beispielsweise vorgesehen sein, einen Spannungspegel am digitalen Schaltausgang zu messen, während der Schaltausgang für eine möglichst kurze Betriebszeit ausgeschaltet wird. Ein solches kurzzeitiges Ausschalten wird auch als "Austasten" bezeichnet. Wenn das kurze Austasten auch am Schaltausgang beobachtet werden kann, zeigt dieses ein korrektes Ausschaltvermögen mindestens eines Halbleiterschalters an. Für viele Anwendungszwecke ist ein derartiges Austasten, auch wenn es sehr kurz gehalten wird, in Betrieb nicht erwünscht, da es die korrekte Funktion der vom Schaltausgang angesteuerten Last stört.

Aus der Druckschrift EP 1 389 284 B1 ist eine Schaltungsanordnung eines Sicherheitsschaltmoduls bekannt, bei dem parallel zu einem ersten Strompfad, in dem sich mindestens ein Halbleiterschalter befindet, ein zweiter Strompfad mit ebenfalls mindestens einem Halbleiterschalter ausgebildet ist. Im Betrieb wird der Schaltausgang abwechselnd über den einen oder den anderen Strompfad mit Spannung beaufschlagt, wobei der jeweils nicht aktive Strompfad hinsichtlich der Funktion seiner Halbleiterschalter überprüft wird. Auf diese Weise ist es möglich, in Betrieb bei eingeschaltetem Schaltausgang die verwendeten Halbleiterschalter zu überprüfen, ohne dass der Schaltausgang durch den Prüfausgang kurzzeitig ausgetastet werden muss. Diese Funktionalität führt jedoch zu einer Verdopplung der Anzahl der Halbleiterschalter und einer komplexeren Überprüfungsschaltung.

Aus der Druckschrift US 2006/0170443 A1 ist eine Schaltung zum Überprüfen des Schaltverhaltens von FETs (Field Effect Transistor) bekannt, insbesondere von solchen Transistoren, die in integrierten Gleichspannungswandler-Modulen eingesetzt sind.

Die Druckschrift EP 2 139 117 A1 zeigt ein Prüfverfahren, bei welchem sichergestellt wird, dass eine Entladeschaltung den Pegel am Ausgang absenken kann.

Dokument EP 1 873 916 A2 zeigt eine Schaltanordnung, bei der zwei seriell verschaltete Halbleiterschalter im laufenden Betrieb mittels einer Rückleseschaltung auf deren Ausschaltfähigkeit überprüft werden.

Die Druckschrift DE 10 2012 203995 A1 zeigt eine Schaltanordnung mit digitalem Schaltausgang, bei der das Schaltelement vor Spannungsspitzen einer Leitungsinduktivität beim Ausschalten durch ein Freilaufelement geschützt ist.

Es ist eine Aufgabe der vorliegenden Erfindung, eine Schaltungsanordnung mit einem digitalen Schaltausgang der eingangs genannten Art und ein Ausgangsmodul bereit zu stellen, die bei einer möglichst geringen Anzahl verwendeter Halbleiterschalter eine Überprüfung derselben zulassen, ohne dass am Schaltausgang durch die Überprüfung eine kurzzeitige Austastung auftritt. Es ist eine weitere Aufgabe, ein Prüfverfahren für eine derartige Schaltungsanordnung zu beschreiben, die bei einfachem Aufbau der Schaltungsanordnung eine Überprüfung der korrekten Funktion eines Halbleiterschalters der Schaltungsanordnung ohne Unterbrechung der Versorgung der Last ermöglicht.

Diese Aufgabe wird gelöst durch eine Schaltungsanordnung, ein Ausgangsmodul und ein Prüfverfahren mit den jeweiligen Merkmalen der unabhängigen Ansprüche. Vorteilhafte Ausgestaltung und Weiterbildung sind in den abhängigen Ansprüchen angegeben.

Eine erfindungsgemäße Schaltungsanordnung der eingangs genannten Art zeichnet sich dadurch aus, dass der mindestens eine Halbleiterschalter über eine Induktivität mit dem Schaltausgang verbunden ist, wobei ein Verbindungsknoten zwischen dem mindestens einen Halbleiterschalter und der Induktivität über ein Freilaufelement mit dem weiteren Ausgang verbunden ist.

Ein Ausschalten des mindestens einen Halbleiterschalters führt bei der erfindungsgemäßen Schaltungsanordnung nicht zu einem unmittelbaren Abschalten der Last. Stattdessen wird der Stromfluss durch das zusammenbrechende Magnetfeld der Induktivität aufrechterhalten und fließt über die Induktivität, die Last und das Freilaufelement kurzzeitig weiter. Dieses kann zu einer Überprüfung des korrekten Abschaltens des Halbleiterschalters ausgenutzt werden: Während eines kurzen Austastpulses des Halbleiterschalters bei einem Test führt die Kombination aus Induktivität und Freilaufelement dazu, dass ein Stromfluss durch die angeschlossene Last zunächst weiter aufrechterhalten wird. Die Überprüfung kann absolviert werden, ohne dass sich die Austastung an der Last zeigt.

Zur Durchführung der Uberprüfung weist die Schaltungsanordnung erfindungsgemäß eine Ansteuer- und Prüfschaltung auf, die den mindestens einen Halbleiterschalter ansteuert und ermittelt, ob ein kurzer Austastpuls in der Ansteuerung des mindestens einen Halbleiterschalters an einem Prüfanschluss beobachtbar ist. Der Prüfanschluss kann dabei an dem Verbindungsknoten zwischen dem mindestens einen Halbleiterschalter und der Induktivität angeschlossen sein. Alternativ ist es auch möglich, den Prüfanschluss an dem Schaltausgang anzuschließen. In dem Fall kann die Ansteuer- und Prüfschaltung dazu eingerichtet sein, aus einer am Schaltausgang bestimmten Spannungsänderung während eines Austastpulses einen am Schaltausgang fließenden Strom zu bestimmen. Als Nebeneffekt wird so eine Strommessung ohne zusätzliches Strommessmittel, also beispielsweise ohne Shunt, ermöglicht. Der so bestimmte Stromwert kann ebenfalls überwacht werden und ermöglicht Aussagen über eventuelle Probleme beim Anschluss der Last, z. B. einen Leitungsbruch.

In einer vorteilhaften Ausgestaltung der Schaltungsanordnung sind zur Erhöhung der Schaltsicherheit zwei oder mehr Halbleiterschalter in Serie geschaltet.

In einer weiteren vorteilhaften Ausgestaltung der Schaltungsanordnung ist zwischen dem Schaltausgang und dem weiteren Ausgang, also parallel zur Last, ein Kondensator angeordnet. Der Kondensator unterstützt das Aufrechterhalten des Stromflusses am Ausgang während einer kurzen Austastung und minimiert Spannungsänderungen am Ausgang.

In einer weiteren vorteilhaften Ausgestaltung der Schaltungsanordnung weist das Freilaufelement eine Diode auf oder ist eine Diode. Die Diode als Freilaufelement wird aufgrund der sich einstellenden Potenziale leitend und schließt den über Induktivität und Last verlaufenden Stromkreis während einer Austastung sicher. Alternativ oder zusätzlich parallel geschaltet kann ein Transistor als Freilaufelement eingesetzt werden. Er wird zu diesem Zweck synchron zu den Austastpulsen angesteuert. Bei einem geringen Durchgangswiderstand des Transistors können Energieverluste, die bei einer Diode als Freilaufelement anfallen und die zu einer Erwärmung der Diode führen können, vermieden werden.

In einer weiteren vorteilhaften Ausgestaltung der Schaltungsanordnung ist der weitere Ausgang ebenfalls geschaltet und über mindestens einen weiteren Halbleiterschalter mit einem weiteren Versorgungsspannungsanschluss verbunden. Auf diese Weise kann eine allpolige Trennung realisiert werden.

In einer weiteren vorteilhaften Ausgestaltung der Schaltungsanordnung ist dem mindestens einen Halbleiterschalter und/oder dem mindestens einen weiteren Halbleiterschalter ein Verpolungsschutzschalter vorgeschaltet.

Ein erfindungsgemäßes Ausgangsmodul für eine Automatisierungssteuerung, weist mindestens einen digitalen Schaltausgang auf und zeichnet sich durch eine vorgenannte Schaltungsanordnung zur Ansteuerung des mindestens einen digitalen Schaltausgangs aus. Es ergeben sich die im Zusammenhang mit der Schaltungsanordnung genannten Vorteile.

Ein erfindungsgemäßes Prüfverfahren für eine zuvor beschriebene Schaltungsanordnung umfasst die folgenden Schritte: Der mindestens eine Halbleiterschalter wird zum Betreiben der mit dem Schaltausgang verbundenen Last angesteuert, so dass die Last über den Halbleiterschalter mit Strom versorgt wird. Dann wird die Ansteuerung des mindestens einen Halbleiterschalters kurzzeitig unterbrochen, wobei die Last während der Unterbrechung durch in der Induktivität gespeicherte Energie weiter mit Strom versorgt und somit unterbrechungsfrei betrieben wird. Während der Unterbrechung der Ansteuerung des mindestens einen Halbleiterschalters wird ermittelt, ob dieser auch korrekt sperrt, ob er also in der Lage ist, die Last tatsächlich wenn gewünscht abzuschalten. Die Ermittlung umfasst beispielsweise eine Bestimmung einer Spannung am Ausgangsanschluss des Halbleiterschalters. Danach wird der mindestens eine Halbleiterschalter wieder so angesteuert, dass er die mit dem Schaltausgang verbundene Last weiter versorgt. Es wird somit ausgenutzt, dass die Induktivität die Last kurzfristig während der Überprüfung weiter mit Strom versorgt, so dass die Überprüfung im Hinblick auf den Betrieb der Last unterbrechungsfrei stattfinden kann. Es ergeben sich die bereits zuvor genannten Vorteile.

In einer vorteilhaften Weiterbildung des Prüfverfahrens werden die Schritte des Unterbrechens der Ansteuerung des mindestens einen Halbleiterschalters und des Ermittelns, ob der mindestens eine Halbleiterschalter korrekt sperrt, wiederholt durchgeführt. Die Wiederholung kann z.B. periodisch wiederkehrend erfolgen. Auf diese Weise kann die korrekte Funktionalität des Halbleiterschalters, insbesondere seine Fähigkeit, die Last von der Versorgungsspannung zu trennen, ständig sichergestellt werden.

Die Schaltungsanordnung wird nachfolgend anhand von Ausführungsbeispielen mit Hilfe von drei Figuren näher erläutert. Die Figuren zeigen:
- Fig. 1: ein erstes Ausführungsbeispiel einer Schaltungsanordnung für einen digitalen Schaltausgang;
- Fig. 2: ein zweites Ausführungsbeispiel einer Schaltungsanordnung für einen digitalen Schaltausgang und
- Fig. 3: ein drittes Ausführungsbeispiel einer Schaltungsanordnung für einen digitalen Schaltausgang.

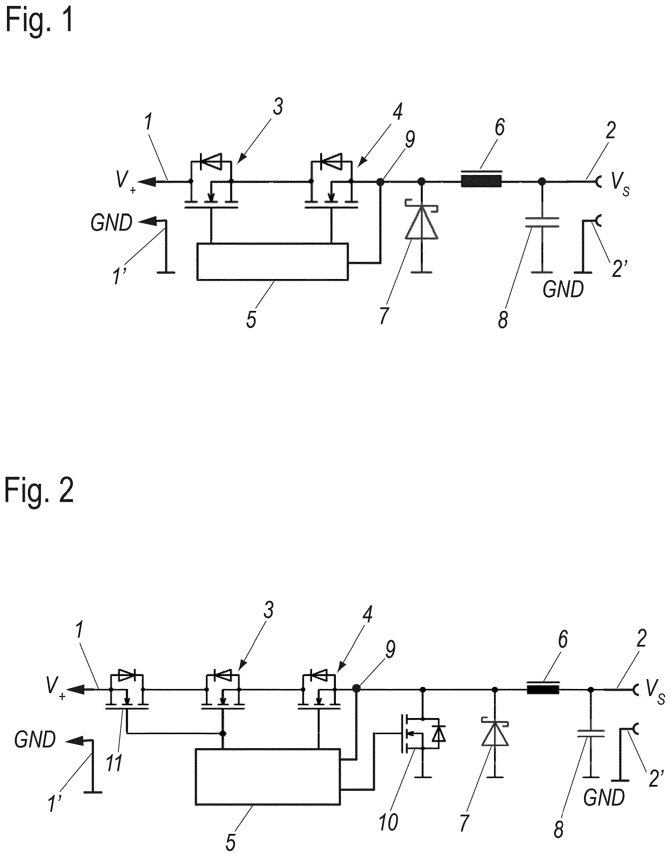

Fig. 1 zeigt in einem Prinzipschaltbild ein erstes Ausführungsbeispiel einer Schaltungsanordnung für einen digitalen Schaltausgang.

Die Schaltungsanordnung weist einen Versorgungsspannungsanschluss 1 auf, der mit einer Versorgungsspannung V₊ beaufschlagt wird. Die Versorgungsspannung V₊ bezieht sich auf einen Referenzspannungspegel, der beim dargestellten Ausführungsbeispiel durch ein Massepotential GND gebildet wird. Das Massepotential wird über einen Referenzspannungsanschluss (Masseanschluss) 1' bereitgestellt. Die Versorgungsspannung V₊ und das Massepotential GND werden beispielsweise durch ein hier nicht dargestelltes externes Netzteil bereitgestellt.

Die Schaltungsanordnung ist beispielsweise Teil eines Ausgangsmoduls, das innerhalb einer industriellen Automatisierungsanlage eingesetzt wird. Die Schaltungsanordnung weist einen digitalen Schaltausgang 2 auf bzw. ist mit diesem verbunden, der von der Schaltungsanordnung mit einer ein- bzw. ausschaltbaren Ausgangsspannung Vₛ beaufschlagt wird. Die Ausgangsspannung Vₛ bezieht sich wiederum auf das Massepotenzial GND, das auch an einem weiteren Ausgang 2' der Schaltungsanordnung bereitgestellt wird. Die Schaltungsanordnung dient dem sicheren gesteuerten Ein- bzw. Ausschalten einer zwischen dem Schaltausgang 2 und dem weiteren Ausgang 2' angeschlossenen Last.

Zwischen dem Versorgungsspannungsanschluss 1 und dem Schaltausgang 2 sind in diesem Ausführungsbeispiel zwei in Serie geschaltete Halbleiterschalter 3, 4 angeordnet. Vorliegend sind MOSFET (metal oxide semiconductor field effect transistor)-Transistoren als Halbleiterschalter eingesetzt. Die Halbleiterschalter 3, 4 weisen eine interne Bypass Diode auf. Es versteht sich, dass anstelle der dargestellten MOSFET-Transistoren beispielsweise auch Bipolartransistoren oder IGBT (insulated gate bipolar transistor)-Transistoren eingesetzt werden können.

Die Verwendung von zwei in Reihe geschalteten Halbleiterschaltern 3, 4 geschieht aus Redundanzgründen zur Erhöhung der Schaltsicherheit, insbesondere der Abschaltsicherheit.

Angesteuert werden die Halbleiterschalter 3, 4 über ihren Steueranschluss (hier ihren Gateanschluss) von einer Ansteuer- und Prüfschaltung 5. Die Ansteuer- und Prüfschaltung 5 erhält ihrerseits ein Eingangssignal über einen hier nicht dargestellten Eingang und schaltet die Halbleiterschalter 3, 4 entsprechend dem Eingangssignal ein oder aus.

Anmeldungsgemäß ist zwischen die Halbleiterschalter 3, 4 und den Schaltausgang 2 eine Induktivität 6 geschaltet und es ist eine Diode 7 als Schaltorgan zwischen das Referenzpotenzial und den Verbindungsknoten zwischen der Serienschaltung der Halbleiterschalter 3, 4 und der Induktivität geschaltet. Vorteilhaft ist darüber hinaus zwischen den Ausgängen 2, 2' ein Kondensator 8 geschaltet.

Die dargestellte Schaltungsanordnung dient dem gesteuerten An- und Ausschalten einer an dem Schaltausgang 2 bzw. dem weiteren Ausgang 2' angeschlossenen Last. Um im eingeschalteten Zustand des Schaltausgangs 2 ein korrektes Funktionieren der Halbleiterschalter 3, 4 überprüfen zu können, ist die Ansteuer- und Prüfschaltung 5 dazu ausgelegt, die Halbleiterschalter 3, 4 unabhängig voneinander, beispielsweise abwechselnd mit dazwischenliegenden Pausen nacheinander, regelmäßig kurz aus und dann wieder einzuschalten, also kurz auszutasten. Am Ausgang der Reihenschaltung der Halbleiterschalter 3, 4, also an dem Verbindungsknoten zur Induktivität 6, ist ein Prüfanschluss 9 angeordnet, dessen Potenzial von der Ansteuer- und Prüfschaltung 5 gemessen und überprüft wird. An dem Prüfanschluss 9 zeigt sich, ob eine Austastung der Ansteueranschlüsse, also der Gateanschlüsse der Halbleiter 3, 4 auch erfolgreich zum Unterbrechen der Schaltstrecke der Halbleiterschalter 3, 4 geführt hat.

Das Austasten eines der Halbleiterschalter 3, 4 führt zu einer Unterbrechung des Stromflusses zwischen der Reihenschaltung der Halbleiterschalter 3, 4 und der Induktivität 6. Gemäß der Lenz'schen Regel wird der Stromfluss durch das zusammenbrechende Magnetfeld der Induktivität 6 aufrechterhalten, wodurch die Diode 7 leitend wird. Während des kurzen Austastpulses führt die Kombination aus Induktivität 6 und Diode 7 somit dazu, dass ein Stromfluss durch die angeschlossene Last zunächst weiter aufrechterhalten wird. Der sich ausbildende Stromkreis führt über die Diode 7, die Induktivität 6 und die am Schaltausgang 2 bzw. dem weiteren Ausgang 2' angeschlossene Last.

Der optional parallel zur Last angeordnete Kondensator 8 unterstützt dieses Verhalten und hält die Versorgungsspannung V₊ gegenüber dem Massepotenzial GND zusätzlich aufrecht. Der Induktivitätswert der Induktivität 6, die beispielsweise durch eine Spule, bevorzugt mit einem Kern, beispielsweise einem Ferritkern, ausgebildet ist, ist so bemessen, dass für die Dauer des Austastpulses die Spannung am Schaltausgang 2 möglichst mit nur geringem Spannungseinbruch aufrecht gehalten wird. Die Austastzeiten können vorteilhaft im Bereich von einigen 10 Mikrosekunden (µs) bis weniger als 1 µs liegen, um auch größere Ströme im Bereich von einigen Ampere (A) durch die Induktivität 6 ausreichend lange liefern zu können, ohne dass die Induktivität 6 einen allzu großen Induktivitätswert aufweisen muss. Während der Austastzeit ist für die meisten angeschlossenen Lasten ein Spannungseinbruch um maximal etwa 5% - 7% tolerierbar. Bei einer Versorgungsspannung V₊ von 24 Volt (V) ist beispielsweise ein Einbruch um 1,5 V in der Regel tolerierbar. Durch Anpassung der Größe des Induktivitätswertes der Induktivität 6 kann, wenn erforderlich, auch ein kleiner Spannungseinbruch realisiert werden.

Während die Ausgangsspannung Vₛ am Schaltausgang 2 auf diese Weise während des Austastpulses im Wesentlichen aufrecht erhalten wird, sinkt sie bei korrekt arbeitendem Halbleiterschaltern 3, 4 am Prüfanschluss 9 auf eine Spannung ab, die der Durchbruchspannung der Diode 7 entspricht. Dieses Absenken von der Versorgungsspannung V₊ auf die Durchgangsspannung der Diode, die bezogen auf das Massepotenzial am Prüfanschluss 9 negativ und typischerweise kleiner als ein Volt ist, wird von der Ansteuer- und Prüfschaltung 5 detektiert und als Zeichen eines korrekt abschaltenden Halbleiterschalters 3, 4 gewertet. Sinkt die Spannung am Prüfanschluss 9 nicht ab, deutet dieses auf einen defekten, beispielsweise durchgeschmolzenen Halbleiterschalter 3 und/oder 4 hin oder darauf, dass am Ausgang keine Last angeschlossen ist. Letzteres kann ebenfalls als potentieller Fehler gedeutet werden, da es z.B. durch einen Kabelbruch verursacht sein kann.

In einer alternativen Ausgestaltung der Schaltungsanordnung kann als Prüfanschluss der Schaltausgang 2 selbst dienen, wobei in diesem Fall von der Ansteuer- und Prüfschaltung 5 kein Absinken auf den geringen Spannungswert der Durchbruchsspannung der Diode 7 detektiert werden kann, sondern lediglich ein geringes Absinken, das daher rührt, dass die Induktivität 6 und der Kondensator 8 ein exponentielles Entladeverhalten zeigen. Auch wenn die anmeldungsgemäße Anordnung von Induktivität 6 und Diode 7 und gegebenenfalls Kondensator 8 geeignet sind, die Ausgangsspannung Vₛ am Schaltausgang insoweit aufrecht zu erhalten, dass eine eingeschlossene Last problemlos weiter versorgt werden kann, so stellt sich doch ein detektierbares Absinken der Spannung Vₛ am Schaltausgang 2 ein.

Vorteilhafter bei der Messung der Spannung am Kondensator 8 ist, dass aus der Spannungsänderung am Kondensator 8 auf eine Größe des am Ausgang fließenden Stroms geschlossen werden kann bzw. darauf geschlossen werden kann, ob am Ausgang überhaupt Strom fließt. Der bestimmt Stromwert bzw. der Stromfluss als solches kann ebenfalls überwacht werden und ermöglicht Aussagen über eventuelle Probleme beim Anschluss der Last, z. B. einen Leitungsbruch.

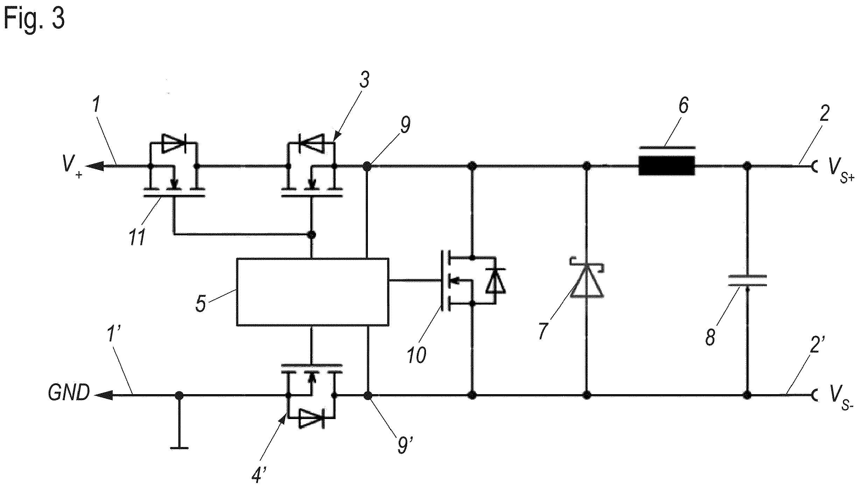

Fig. 2 zeigt in ähnlicher Weise wie Fig. 1 in einem schematischem Schaltbild ein zweites Ausführungsbeispiel einer anmeldungsgemäßen Schaltungsanordnung für einen digitalen Schaltausgang. Gleiche Bezugszeichen kennzeichnen in dieser wie auch in der folgenden Fig. 3 gleiche oder gleichwirkende Elemente wie beim Ausführungsbeispiel der Fig. 1.

Im Grundaufbau entspricht die in Fig. 2 dargestellte Schaltungsanordnung der in Fig. 1 gezeigten, auf die hiermit ausdrücklich verwiesen wird.

Im Unterschied zum Ausführungsbeispiel der Fig. 1 ist vorliegend parallel zur Diode 7 ein Transistor 10, wiederum ein MOSFET-Transistor, angeordnet. Bei dem Ausführungsbeispiel der Fig. 1 stellt die Diode 7 ein nicht angesteuertes Freilaufelement dar, das während eines Austastens eines der Halbleiterschalter 3, 4 aufgrund der sich an ihren Anschlüssen einstellenden Potenziale leitend wird.

Der Transistor 10 stellt ebenso ein Freilaufelement mit der gleichen Funktion wie die Diode 7 dar. Er wird zu diesem Zweck von der Ansteuer- und Prüfschaltung 5 synchron zu den Austastpulsen angesteuert. Der Durchgangswiderstand des Transistors 10 ist so gering, dass im leitenden Zustand ein nur geringer, vernachlässigbarer Spannungsabfall über dem Transistor 10 abfällt. Entsprechend sind Energieverluste, die bei der Schaltungsanordnung der Fig.1 an der Diode 7 anfallen und die zu einer Erwärmung der Diode 7 führen können, vermieden. Geringere Energieverluste führen auch dazu, dass die am Schaltausgang 2 angeschlossene Last länger von der in der Induktivität 6 bzw. dem Kondensator 8 gespeicherten Energie versorgt werden kann. Bei vorgegebener Länge der Austastpulse können die Induktivität 6 und der Kondensator 8 somit mit kleinerer Induktivität bzw. Kapazitätswerten dimensioniert werden.

Ein weiterer Unterschied zum Ausführungsbeispiel der Fig. 1 liegt in einem der Reihenschaltung der Halbleiterschalter 3, 4 vorgeschalteten Verpolungsschutzschalter 11. Dieser könnte passiv durch eine Diode gebildet sein, vorliegend wird zur Verringerung von Spannungsabfällen jedoch ein MOSFET-Transistor verwendet.

Fig. 3 zeigt ein weiteres Ausführungsbeispiel einer anmeldungsgemäßen Schaltungsanordnung für einen digitalen Schaltausgang. In diesem Ausführungsbeispiel wird der Schaltausgang allpolig geschaltet.

Es sind wiederum Versorgungsspannungsanschlüsse 1, 1' für eine positive Versorgungsspannung V₊ und ein Massepotenzial GND vorhanden. Jeder dieser Versorgungsspannungsanschlüsse 1, 1' ist über je einen Halbleiterschalter 3 bzw. 4' mit dem Ausgang der Schaltungsanordnung verbunden. Entsprechend sind beide Pole des Ausgangs geschaltet und in der Fig. 3 als Schaltausgang 2 bzw. weiterer Schaltausgang 2' mit entsprechenden Ausgangsspannungen Vₛ₊ bzw. Vₛ₋ gekennzeichnet.

Es ist ebenso wie bei den zuvor beschriebenen Ausführungsbeispielen eine Ansteuer- und Prüfschaltung 5 vorgesehen, die die beiden Halbleiterschalter 3, 4' ansteuert. Es sind zwei Prüfanschlüsse 9, 9' vorhanden, wobei während eines Austastpulses die zwischen den Prüfanschlüssen 9 und 9' liegende Spannung ermittelt wird.

Wie beim Ausführungsbeispiel der Fig. 2 ist ein Verpolungsschutz 11 vorgesehen, der dem positiven Versorgungsspannungsanschluss 1 nachgeschaltet ist.

Die Schaltungsanordnung aus Induktivität 6, Diode 7 und Kondensator 8, die die Versorgung der am Schaltausgang 2, 2' angeschlossenen Last in den Austastpulsen der Ansteuer- und Prüfschaltung 5 ermöglicht, ist in diesem Ausführungsbeispiel analog zu denen der Fig.1 und 2 aufgebaut, wobei die Induktivität 6 dem Schaltausgang 2 vorgeschaltet ist, und wobei über die Diode 7 der Knoten zwischen dem Halbleiterschalter 3 und einem Anschluss der Induktivität 6 mit dem weiteren Schaltausgang 2' verbunden ist. Der Kondensator ist wiederum parallel zu den Schaltausgängen 2, 2' geschaltet.

Wie beim Ausführungsbeispiel der Fig.2 ist der Diode 7 ein Transistor 10 parallel geschaltet, der während der Austastpulse durch die Ansteuer- und Prüfschaltung 5 angesteuert wird und zusätzlich zur Diode 7 als Freilaufelement dient.

Funktionell ist die in Fig. 3 dargestellte Schaltung der in Fig. 2 dargestellten gleichwertig, mit dem Unterschied, dass beim Abschalten des Schaltausgangs 2, 2' allpolig von der Versorgungsspannung V₊ bzw. GND getrennt wird. Der Vorteil der allpoligen Trennung besteht bei funktionaler Sicherheit insbesondere darin, dass ein externer Kurzschluss einer vom Schaltausgang 2 wegführenden Leitung, der die Last dauerhaft mit der Versorgungsspannung V₊ beaufschlagt, kein Sicherheitsverlust darstellt, da ja auch die vom weiteren Schaltausgang 2' wegführende Leitung abgeschaltet wird.

### Bezugszeichen

- 1,1': Versorgungsspannungsanschluss
- 2: Schaltausgang
- 2': weiterer (Schalt-) Ausgang
- 3,4: Halbleiterschalter
- 4': weiterer Halbleiterschalter
- 5: Ansteuer- und Prüfschaltung
- 6: Induktivität
- 7: Diode
- 8: Kondensator
- 9: Prüfanschluss
- 10: Transistor
- 11: Verpolungsschutzschalter

- V₊: Versorgungsspannung
- Vₛ: geschaltete Ausgangsspannung
- Vₛ₊, Vₛ₋: geschaltete positive bzw. negative Ausgangsspannung
- GND: Massepotenzial

## Patentansprüche

1. Schaltungsanordnung mit einem digitalen Schaltausgang (2) zum Anschluss einer zwischen dem Schaltausgang (2) und einem weiteren Ausgang (2') anschließbaren Last, aufweisend mindestens einen Halbleiterschalter (3, 4), der mit einer Schaltstrecke zwischen einem Versorgungsspannungsanschluss (1) und dem Schaltausgang (2) angeordnet ist, und aufweisend eine Ansteuer- und Prüfschaltung (5) mit einem Eingang, die dazu ausgebildet ist, den mindestens einen Halbleiterschalter (3, 4) entsprechend einem Eingangssignal an dem Eingang ein- oder auszuschalten, wobei der mindestens eine Halbleiterschalter (3, 4) über eine Induktivität (6) mit dem Schaltausgang (2) verbunden ist und wobei ein Verbindungsknoten zwischen dem mindestens einen Halbleiterschalter (3, 4) und der Induktivität (6) über ein Freilaufelement (7) mit dem weiteren Ausgang (2') verbunden ist, **dadurch gekennzeichnet, dass** die Ansteuer- und Prüfschaltung (5) dazu ausgebildet ist, den mindestens einen Halbleiterschalter (3, 4) mittels eines kurzen Austastpulses anzusteuern und zu ermitteln, ob der kurze Austastpuls in der Ansteuerung des mindestens einen Halbleiterschalters (3, 4) an einem Prüfanschluss (9) beobachtbar ist.

2. Schaltungsanordnung nach Anspruch 1, bei der zwischen dem Schaltausgang (2) und dem weiteren Ausgang (2') ein Kondensator (8) angeordnet ist.

3. Schaltungsanordnung nach Anspruch 1 oder 2, bei der das Freilaufelement eine Diode (7) aufweist.

4. Schaltungsanordnung nach einem der Ansprüche 1 bis 3, bei der das Freilaufelement einen Transistor (10) aufweist.

5. Schaltungsanordnung nach Anspruch 3 und 4, bei der der Transistor (10) mit seiner Schaltstrecke der Diode (7) parallel geschaltet ist.

6. Schaltungsanordnung nach einem der Ansprüche 1 bis 5, bei der der weitere Ausgang (2') ein Masseanschluss (GND) ist.

7. Schaltungsanordnung nach einem der Ansprüche 1 bis 6, bei der der weitere Ausgang (2') ebenfalls geschaltet ist und über mindestens einen weiteren Halbleiterschalter (4') mit einem weiteren Versorgungsspannungsanschluss (1') verbunden ist.

8. Schaltungsanordnung nach einem der Ansprüche 1 bis 7, bei der ein Verpolungsschutzschalter (11) dem mindestens einen Halbleiterschalter (3, 4) und/oder dem mindestens einen weiteren Halbleiterschalter (4') vorgeschaltet ist.

9. Schaltungsanordnung nach einem der Ansprüche 1 bis 8, bei der der Prüfanschluss (9) an dem Verbindungsknoten zwischen dem mindestens einen Halbleiterschalter (3, 4) und der Induktivität (6) angeschlossen ist.

10. Schaltungsanordnung nach einem der Ansprüche 1 bis 8, bei der der Prüfanschluss (9) an dem Schaltausgang (2) angeschlossen ist.

11. Schaltungsanordnung nach Anspruch 10, bei der die Ansteuer- und Prüfschaltung (5) dazu eingerichtet ist, aus einer am Schaltausgang (2) bestimmten Spannungsänderung während eines Austastpulses einen am Schaltausgang (2) fließenden Strom zu bestimmen.

12. Ausgangsmodul für eine Automatisierungssteuerung, aufweisend mindestens einen digitalen Schaltausgang (2), **gekennzeichnet durch** eine Schaltungsanordnung nach einem der Ansprüche 1 bis 11.

13. Prüfverfahren für eine Schaltungsanordnung mit einem digitalen Schaltausgang (2) zum Anschluss einer zwischen dem Schaltausgang (2) und einem weiteren Ausgang (2') anschließbarer Last, wobei die Schaltungsanordnung mindestens einen Halbleiterschalter (3, 4) aufweist, der mit einer Schaltstrecke zwischen einem Versorgungsspannungsanschluss (1) und dem Schaltausgang (2) angeordnet ist, wobei der mindestens eine Halbleiterschalter (3, 4) über eine Induktivität (6) mit dem Schaltausgang verbunden ist und wobei ein Verbindungsknoten zwischen dem mindestens einen Halbleiterschalter (3, 4) und der Induktivität (6) über ein Freilaufelement (7) mit dem weiteren Ausgang (2') verbunden ist, mit den folgenden Schritten:
- Ansteuern des mindestens einen Halbleiterschalters (3, 4) zum Betreiben der mit dem Schaltausgang (2) verbundenen Last;
- Unterbrechen der Ansteuerung des mindestens einen Halbleiterschalters (3, 4), wobei die Last während der Unterbrechung durch in der Induktivität (6) gespeicherte Energie betrieben wird;
- Ermitteln, ob während der Unterbrechung der Ansteuerung des mindestens einen Halbleiterschalters (3, 4) sperrt; und
- Ansteuern des mindestens einen Halbleiterschalters (3, 4) zum weiteren Betreiben der mit dem Schaltausgang (2) verbundenen Last.

14. Prüfverfahren nach Anspruch 13, bei dem die Schritte des Unterbrechens der Ansteuerung des mindestens einen Halbleiterschalters (3, 4) und des Ermittelns, ob der mindestens eine Halbleiterschalter (3, 4) korrekt sperrt, wiederholt durchgeführt werden.

## Claims

1. A circuit arrangement having a digital switched output (2) for connecting a load which can be connected between the switched output (2) and another output (2'), said arrangement comprising at least one semiconductor switch (3, 4) arranged, with a switching path, between a supply voltage connection (1) and the switched output (2), and comprising a control and test circuit (5) with an input which is designed to switch the semiconductor switches (3, 4) on or off in accordance with the input, wherein the at least one semiconductor switch (3, 4) is connected to the switched output (2) via an inductance (6), and wherein a connecting node between the at least one semiconductor switch (3, 4) and the inductance (6) is connected to the other output (2') via a free-wheeling element, **characterized in that** the control and test circuit (5) is designed to control the at least one semiconductor switch (3, 4) with a brief blanking pulse and to determine whether the brief blanking pulse in the control of the at least one semiconductor switch (3, 4) is observable at a test connection (9).

2. The circuit arrangement according to Claim 1, in which a capacitor (8) is arranged between the switched output (2) and the other output (2').

3. The circuit arrangement according to Claim 1 or 2, in which the free-wheeling element comprises a diode (7).

4. The circuit arrangement according to any one of Claims 1 to 3, in which the free-wheeling element comprises a transistor (10).

5. The circuit arrangement according to any one of Claims 3 and 4, in which the transistor (10) is connected with the clearance between contacts thereof parallel to the diode (7).

6. The circuit arrangement according to any one of Claims 1 to 5, in which the other output (2') is a ground connection (GND).

7. The circuit arrangement according to any one of Claims 1 to 6, in which the other output (2') is also connected and connected via at least one additional semiconductor switch (4') to an additional supply voltage connection (1').

8. The circuit arrangement according to any one of Claims 1 to 7, in which a polarity protection switch (11) is connected upstream of the at least one semiconductor switch (3, 4) and/or the at least one additional semiconductor switch (4').

9. The circuit arrangement according to one of Claims 1 to 8, in which the test connection (9) is connected to the connecting node between the at least one semiconductor switch (3, 4) and the inductance (6).

10. The circuit arrangement according to one of Claims 1 to 8, in which the test connection (9) is connected to the switched output (2).

11. The circuit arrangement according to Claim 10, in which the control and test circuit (5) is configured so as to determine a current flowing at the switched output (2) from a voltage change determined at the switched output (2) during a blanking pulse.

12. An output module for automated control, comprising at least one digital switched output (2), **characterized by** a circuit arrangement according to any one of Claims 1 to 11.

13. A test method for a circuit arrangement with a digital switched output (2) for the connection of a load which can be connected between the switched output (2) and another output (2'), wherein the circuit arrangement comprises at least one semiconductor switch (3, 4) arranged, with a switching path, between a supply voltage connection (1) and the switched output (2), wherein the at least one semiconductor switch (3, 4) is connected to the switched output (2) via an inductance (6), and wherein a connecting node between the at least one semiconductor switch (3, 4) and the inductance (6) is connected to the other output (2') via a free-wheeling element, having the following steps:
- controlling of the at least one semiconductor switch (3, 4) for the operation of the load connected to the switched output (2);
- interrupting the control of the at least one semiconductor switch (3, 4), wherein the load during the interruption is operated by energy stored in the inductance (6);
- determining whether during the interruption of the control of the at least one semiconductor switch (3, 4) bars; and
- controlling of the at least one semiconductor switch (3, 4) for the further operation of the load connected to the switched output (2).

14. The test method according to Claim 13, in which the steps of the interruption of the control of the at least one semiconductor switch (3, 4) and of the determination of whether the at least one semiconductor switch (3, 4) correctly bars are carried out repeatedly.

## Revendications

1. Dispositif de commutation avec une sortie de commutation numérique (2) pour la connexion d'une charge pouvant être connectée entre la sortie de commutation (2) et une autre sortie (2'), présentant au moins un commutateur à semi-conducteurs (3, 4) dont un trajet de commutation est disposé entre une connexion de tension d'alimentation (1) et la sortie de commutation (2) et qui présente un circuit d'activation et d'essai (5) avec une entrée conçue pour activer ou désactiver l'au moins un commutateur à semi-conducteurs (3, 4) en fonction d'un signal d'entrée sur l'entrée, dans lequel l'au moins un commutateur à semi-conducteurs (3, 4) est connecté par l'intermédiaire d'une inductance (6) à la sortie de commutation (2) et dans lequel un nœud de liaison entre l'au moins un commutateur à semi-conducteurs (3, 4) et l'inductance (6) est connecté par l'intermédiaire d'un élément de roue libre (7) à l'autre sortie (2'), **caractérisé en ce que** le circuit d'activation et d'essai (5) est conçu pour commander l'au moins un commutateur à semi-conducteurs (3, 4) au moyen d'une brève impulsion de suppression et déterminer si la brève impulsion de suppression dans l'activation de l'au moins un commutateur à semi-conducteurs (3, 4) est observable sur une connexion d'essai (9).

2. Dispositif de commutation selon la revendication 1, dans lequel un condensateur (8) est disposé entre la sortie de commutation (2) et l'autre sortie (2').

3. Dispositif de commutation selon la revendication 1 ou 2, dans lequel l'élément de roue libre comporte une diode (7).

4. Dispositif de commutation selon l'une des revendications 1 à 3, dans lequel l'élément de roue libre comporte un transistor (10).

5. Dispositif de commutation selon la revendication 3 et 4, dans lequel le transistor (10) est monté en parallèle avec la diode (7) sur son trajet de connexion.

6. Dispositif de commutation selon l'une des revendications 1 à 5, dans lequel l'autre sortie (2') est un point de mise à la masse (GND).

7. Dispositif de commutation selon l'une des revendications 1 à 6, dans lequel l'autre sortie (2') est également connectée et reliée par l'intermédiaire d'au moins un autre commutateur à semi-conducteurs (4') à une autre connexion de tension d'alimentation (1').

8. Dispositif de commutation selon l'une des revendications 1 à 7, dans lequel un contact de protection contre les inversions de polarité (11) est monté en amont de l'au moins un commutateur à semi-conducteurs (3, 4) et/ou de l'au moins un autre commutateur à semi-conducteurs (4').

9. Dispositif de commutation selon l'une des revendications 1 à 8, dans lequel la connexion d'essai (9) est connectée sur le nœud de liaison entre l'au moins un commutateur à semi-conducteurs (3, 4) et l'inductance (6).

10. Dispositif de commutation selon l'une des revendications 1 à 8, dans lequel la connexion d'essai (9) est connectée sur la sortie de commutation (2).

11. Dispositif de commutation selon la revendication 10, dans lequel le circuit d'activation et d'essai (5) est agencé de façon à déterminer, à partir d'un changement de tension déterminé sur la sortie de commutation (2) pendant une impulsion de suppression, un courant passant par la sortie de commutation (2).

12. Module de sortie pour une commande d'automatisme, présentant au moins une sortie de commutation numérique (2), **caractérisé en ce qu'**il comporte un dispositif de commutation selon l'une des revendications 1 à 11.

13. Procédé d'essai d'un dispositif de commutation muni d'une sortie de commutation numérique (2) pour la connexion d'une charge pouvant être connectée entre la sortie de commutation (2) et une autre sortie (2'), dans lequel le dispositif de commutation comporte au moins un commutateur à semi-conducteurs (3, 4) dont un trajet de connexion est disposé entre une connexion de tension d'alimentation (1) et la sortie de commutation (2), dans lequel l'au moins un commutateur à semi-conducteurs (3, 4) est connecté par une inductance (6) à la sortie de commutation (2) et dans lequel un nœud de liaison entre l'au moins un commutateur à semi-conducteurs (3, 4) et l'inductance (6) est connecté par l'intermédiaire d'un élément de roue libre (7) à l'autre sortie (2'), comprenant les étapes suivantes :
- activation de l'au moins un commutateur à semi-conducteurs (3, 4) pour faire fonctionner la charge reliée à la sortie de commutation (2) ;
- interruption de l'activation de l'au moins un commutateur à semi-conducteurs (3, 4), pendant laquelle la charge fonctionne grâce à l'énergie accumulée dans l'inductance (6) ;
- détermination de l'état bloqué pendant l'interruption de l'activation de l'au moins un commutateur à semi-conducteurs (3, 4) et
- activation de l'au moins un commutateur à semi-conducteurs (3, 4) pour poursuivre le fonctionnement de la charge reliée à la sortie de commutation (2).

14. Procédé d'essai selon la revendication 13, dans lequel les étapes de coupure de l'activation de l'au moins un commutateur à semi-conducteurs (3, 4) et de détermination de l'état bloqué correct de l'au moins un commutateur à semi-conducteur (3, 4) sont exécutées de façon répétée.
